# EUROPEAN PATENT SPECIFICATION

(11) **EP 0 335 019 B1**
(45) Date of publication and mention of the grant of the patent: **26.05.1993**
(21) Application number: 88302802.9
(22) Date of filing: 29.03.1988
(51) Int. Cl.: H01L 21/58

(54) **Semiconductor chip bonded to a substrate**
Halbleiterchip, verbunden mit einem Substrat
Puce semi-conductrice attachée à un substrat

(43) Date of publication of application: 04.10.1989
(73) Proprietor: Director General, Agency of Industrial Science and Technology, Tokyo 100 (JP)
(72) Inventor: Iwade, Shuhei c/o LSI Kenkyusho of, Itami City Hyogo Prefecture (JP)
(74) Representative: Lawson, David Glynne

(56) References cited:
- EP-A- 0 189 791
- PATENT ABSTRACTS OF JAPAN, vol. 7, no. 58 (E-163)[1203], 10th March 1983; & JP-A-57 204 138
- PATENT ABSTRACTS OF JAPAN, vol. 9, no. 69 (E-305)[1792], 29th March 1985; & JP-A-59 208 735
- SOLID STATE TECHNOLOGY, vol. 6, no. 10, octobre 1973, pages 55-58; J. KIMBALL: "Epoxy device bonding and die handling techniques for hybrid microcircuits"
- PATENT ABSTRACTS OF JAPAN, vol. 11, no. 265 (E-535)[2712], 27th August 1987; & JP-A-62 69 640 )

## Description

### BACKGROUND OF THE INVENTION

This invention relates to a semiconductor device and more particularly, to a semiconductor device in which a semiconductor chip is bonded to a substrate.

### PRIOR ART

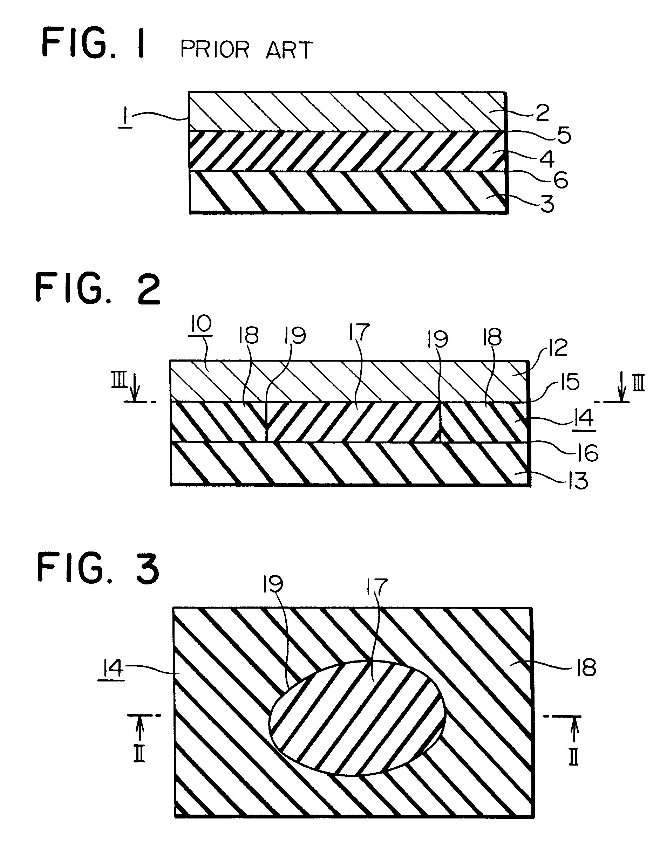

Fig. 1 illustrates, in cross section, a conventional semiconductor device 1 of the type to which the present invention is applicable. The semiconductor device 1 comprises a semiconductor chip 2, a substrate 3 for supporting the semiconductor chip 2, and a bonding layer 4 of a bonding agent disposed between the semiconductor chip 2 and the substrate 3 for bonding the semiconductor chip on the substrate 3. The semiconductor chip 2 is bonded to the substrate 3 by first applying the bonding layer 4 of the bonding agent over the entire surface of the substrate on which the semiconductor chip 2 is to be attached. Then, the semiconductor chip 2 is placed on the bonding agent layer 4. Thus, a bonded interface 5 is formed between the semiconductor chip 2 and the bonding agent layer 4, and another bonded interface 6 is formed between the bonding agent layer 4 and the substrate 3. The bonding agent usually used for this purpose includes epoxy resins, which are hard are rigid bonding agents exhibiting a strong bond in order to ensure that the semiconductor chip 2 is not moved relative to the substrate by external forces or vibrations.

When the semiconductor device 1 is in operation or when the environmental temperature is increased, the semiconductor device 1 is heated and thermally expands. However, since the coefficients of the thermal expansion of the semiconductor chip 2 and the substrate 3 are different, a lateral stress is generated at the bonded interfaces 5 and 6 of the semiconductor chip 2 and the substrate 3. This often causes the separation of the semiconductor chip 2 from the substrate at the bonded surfaces 5 and 6. This separation is aggrevated when the semiconductor device 1 is repeatedly heated. Since the stress at the interfaces 5 and 6 due to the thermal expansion is greater in the peripheral portion of the bonded surfaces than in the central portion, separation at the interfaces 5 and 6 appears more easily at the peripheral portion of the interfaces 5 and 6 than at the central portion.

Once a separation is generated, moisture can easily enter into the interfaces 5 and 6 to promote the water dissolution of the bonding agent 4 fastering further growth in the separation and often resulting in a complete separation of the semiconductor chip 2 from the substrate 3.

When a bonding agent, which usually has a relatively weak bonding ability, is used for the bonding agent 4 in order to cope with the above-discussed problem of the differences in thermal expansion, the bonded interfaces are easily influenced by external vibrations and forces, resulting in the positional displacement and separation of the semiconductor chip with respect to the substrate. This is particularly true with elongated semiconductor chips, such as those used in linear image sensors.

Japanese Patent Abstract of Japan Vol. 9 No. 69 (relating to Japanese Patent Application JP-A-59 208 735) relates to a bonding technique for a semiconductor device in which a high bonding strength and a good heat conduction can be provided at the same time. A first bonding material layer includes a large amount of silver for establishing a conductive bond. An outer bonding area has less silver but a large bonding agent for a large bonding strength.

European Patent Application EP-A-0 189 791 relates to a solder interconnection structure for joining semiconductor devices to substrates. The arrangement described is an improvement in solder reflow controlled collapse chip connection (C-4) technology. Forces are cancelled out by fixing the semiconductor device to the substrate at its periphery, while leaving an unbonded portion in the centre.

### SUMMARY OF THE INVENTION

Accordingly, an object of the present invention is to provide a semiconductor device in which the separation of the semiconductor chip from the substrate at the bonded interface is eliminated.

Another object of the present invention is to provide a semiconductor device in which the difference in thermal expansion between the semiconductor chip and the substrate are efficiently accommodated.

Still another object of the present invention is to provide a semiconductor device in which the semiconductor chip is firmly and reliably bonded.

According to the present invention, there is provided a semiconductor device comprising a semiconductor chip, a substrate supporting said semiconductor chip, and a bonding layer comprising a plurality of bonding agents, disposed between said semiconductor chip and said substrate, bonding said semiconductor chip on said substrate, characterised in that said bonding layer comprises a substantially rigid layer portion of a substantially rigid bonding agent disposed at the central region of said bonding layer to exhibit a strong and rigid bond between the semiconductor chip and the substrate, and a substantially resilient layer portion of a substantially resilient bonding agent disposed around said rigid layer portion in the plane parallel to the chip and substrate bonded interfaces, said resilient layer portion having a sufficient resilience for accommodating thermal expansion differences between said semiconductor chip and said substrate.

The rigid bonding agent may be an epoxy resin, and the resilient bonding agent may be a urethane resin. The rigid bonding agent may have a Young's modulus of about 9.02 GPa (919 kg/mm²) and the resilient bonding agent Young's modulus of about 2.75 GPa (280 kg/mm²).

According to the present invention, large stress appearing at the peripheral portion of the semiconductor device due to thermal expansion is accommodated by the resilient bonding agent disposed peripherally around the rigid bonding agent.

### BRIEF DESCRIPTION OF THE DRAWINGS

The present invention will become more readily apparent from the following detailed description of the preferred embodiment of the present invention shown by way of example in the accompanying drawings, in which
Fig. 1 is a sectional view showing a conventional semiconductor device in which the semiconductor chip is bonded to the substrate;
Fig. 2 is a sectional view taken along line II -II of Fig. 3 showing a semiconductor device of the present invention in which the semiconductor chip is bonded to the substrate to two kind of bonding agents; and
Fig. 3 is a sectional view taken along line III -III of Fig. 2 showing a bonding agent of the semiconductor device.

### DESCRIPTION OF THE PREFERRED EMBODIMENT

Figs. 2 and 3 illustrate, in cross section, a semiconductor device 10 constructed in accordance with the present invention. The semiconductor device 10 comprises a semiconductor chip 12, a substrate 13 for supporting the semiconductor chip 12, and a bonding layer 14 disposed between the semiconductor chip 12 and the substrate 13 for securely bonding the semiconductor chip on the substrate 13. The semiconductor chip 12 is bonded to the substrate 13 by first applying the bonding layer 14 over the entire surface of the substrate on which the semiconductor chip 12 is to be attached. Then, the semiconductor chip 12 is placed on the bonding layer 14. Thus, a bonded interface 15 is formed between the semiconductor chip 12 and the bonding layer 14, and another bonded interface 16 is formed between the bonding agent layer 14 and the substrate 13.

According to the present invention, the bonding layer 14 comprises a rigid layer portion 17 of a substantially rigid or less resilient bonding agent disposed at the central region of the bonding layer 14, and a resilient layer portion 18 of a substantially resilient bonding agent disposed around the rigid layer 17. A circular boundary 19 is formed between the rigid layer 17 and the resilient layer 18. The resilient bonding agent should have sufficient resilience to accomodate the differences in thermal expansion between the semiconductor chip 12 and the substrate 13. Typically, the rigid bonding agent for the rigid layer 17 is an epoxy resin, and the resilient layer 18 for the resilient bonding agent is a urethane resin. Preferably, the rigid bonding agent has a Young's modulus of about 9.02 GPa (919 kg/mm²) and the resilient bonding agent has a Young's modulus of about 2.75 GPa (280 kg/mm²).

Thus, the hard and rigid layer 17 of a rigid bonding agent disposed at the central portion of the bonding agent layer 14 exhibits a strong and rigid bond between the semiconductor chip 12 and the substrate 13 to ensure that the semiconductor chip 12 does not move relative to the substrate 13 even when an external force or vibration is applied. On the contrary, the soft and resilient layer 18 of a resilient bonding agent disposed at the peripheral portion of the bonding agent layer 14 exhibits a relatively strong but resilient bond between the semiconductor chip 12 and the substrate 13 to ensure that the peripheral portion of the semiconductor chip 12 can slightly move relative to the substrate 13 to accomodate the differences in thermal expansion between the chip 12 and the substrate 13 and while still maintaining a firm bond therebetween.

When the semiconductor device 10 is in operation or the environmental temperature is increased to heat and thermally expand the semiconductor device 10, the semiconductor chip 12 and the substrate 13 expand by amounts different from one another since the coefficients of thermal expansion of the semiconductor chip 12 and the substrate 13 are different. However, substantially no lateral stress due to this thermal expansion difference is generated at the bonded interfaces 15 and 16 of the semiconductor chip 12 and the substrate 13 because the resilient bonding agent layer 18 accommodates or absorbs the differences in thermal expansion between the semiconductor chip 12 and the substrate 13. Therefore no separation of the semiconductor chip 12 from the substrate 13 at the bonded surfaces 15 and 16 is generated.

Since separation is not generated, it is difficult for moisture to enter into the interfaces 15 and 16, so that water dissolution of the bonding agent layer 14 is prevented from promoting the further growth of the separation.

While the present invention has been described in conjunction with a single embodiment in which the two kinds of bonding agent layers are used, three or more bonding agent layers can equally be used. This arrangement is preferable when a sudden change in the bonding strength between the semiconductor chip and the substrate is not desirable.

As has been described, according to the semiconductor device of the present invention, a semiconductor chip is attached to a substrate by two kinds of bonding agents, one of which is rigid and disposed at the central region of the semiconductor chip, the other of which is disposed around the rigid bonding agent and is sufficiently resilient to accomodate thermal expansion difference between the semiconductor chip and the substrate. Therefore, the problem of the separation of the semiconductor chip from the substrate at the bonded interface is eliminated, the differences in thermal expansion between the semiconductor chip and the substrate are efficiently accomodated, and the semiconductor chip is firmly and reliably bonded to the substrate.

## Claims

1. A semiconductor device comprising a semiconductor chip (2, 12), a substrate (3, 13) supporting said semiconductor chip, and a bonding layer (4, 14) comprising a plurality of bonding agents, disposed between said semiconductor chip (12) and said substrate (13), bonding said semiconductor chip on said substrate, characterised in that said bonding layer comprises a substantially rigid layer portion (17) of a substantially rigid bonding agent disposed at the central region (19) of said bonding layer to obtain a strong and rigid bond between the semiconductor chip (12) and the substrate (13), and a substantially resilient layer portion (18) of a substantially resilient bonding agent disposed around said rigid layer portion (17) in the plane parallel to the chip and substrate bonded interfaces (15, 16), said resilient layer portion (18) having a sufficient resilience for accommodating thermal expansion differences between said semiconductor chip and said substrate.

2. A semiconductor device as claimed in claim 1, wherein said rigid bonding agent is an epoxy resin and said resilient bonding agent is a urethane resin.

3. A semiconductor device as claimed in claim 1, wherein said rigid bonding agent has a Young's modulus of about 9.02 GPa (920 kg/mm²) and said resilient bonding agent has a Young' s modulus of about 2.75 GPa (280 kg/mm²).

4. A semiconductor device as claimed in claim 1, wherein said bonding layer (14) further comprises an intermediate layer portion disposed between said rigid layer portion (17) and said resilient layer portion (18), said intermediate layer portion having a resilience between those of said rigid layer portion and said resilient layer portion.

## Patentansprüche

1. Halbleiterbauelement, das folgendes aufweist: einen Halbleiterchip (2, 12), ein Substrat (3, 13), das den Halbleiterchip trägt, und eine Verbindungsschicht (4, 14), die eine Vielzahl von Verbindungsmitteln aufweist, zwischen dem Halbleiterchip (12) und dem Substrat (13) angeordnet ist und den Halbleiterchip mit dem Substrat verbindet,
dadurch gekennzeichnet,
daß die Verbindungsschicht folgendes aufweist: einen im wesentlichen harten Schichtbereich (17) aus einem im wesentlichen harten Verbindungsmittel, der in dem Mittelbereich (19) der Verbindungsschicht angeordnet ist, um eine starke und harte Verbindung zwischen dem Halbleiterchip (12) und dem Substrat (13) zu erhalten, und einen im wesentlichen elastischen Schichtbereich (18) aus einem im wesentlichen elastischen Verbindungsmittel, der um den harten Schichtbereich (17) herum in der Ebene angeordnet ist, die zu den Chip- und Substrat-Verbindungsgrenzflächen (15, 16) parallel ist, wobei der elastische Schichtbereich (18) eine ausreichende Elastizität hat, um Wärmeausdehnungsunterschiede zwischen dem Halbleiterchip und dem Substrat aufzunehmen.

2. Halbleiterbauelement nach Anspruch 1, wobei das harte Verbindungsmittel ein Epoxidharz und das elastische Verbindungsmittel ein Urethanharz ist.

3. Halbleiterbauelement nach Anspruch 1, wobei das harte Verbindungsmittel einen Elastizitätsmodul von ca. 9,02 GPa (920 kg/mm²) und das elastische Verbindungsmittel einen Elastizitätsmodul von ca. 2,75 GPa (280 kg/mm²) hat.

4. Halbleiterbauelement nach Anspruch 1, wobei die Verbindungsschicht (14) ferner einen Zwischenschichtbereich aufweist, der zwischen dem harten Schichtbereich (17) und dem elastischen Schichtbereich (18) angeordnet ist, wobei der Zwischenschichtbereich eine Elastizität zwischen der des harten Schichtbereichs und der des elastischen Schichtbereichs hat.

## Revendications

1. Dispositif semi-conducteur comprenant une puce semi-conductrice (2,12), un substrat (3,13) supportant ladite puce semi-conductrice, et une couche de liaison (4,14) comprenant une pluralité d'agents de liaison disposés entre ladite puce semi-conductrice (12) et ledit substrat (13), liant ladite puce semi-conductrice sur ledit substrat, caractérisé en ce que ladite couche de liaison comprend une portion de couche essentiellement rigide (17) d'un agent de liaison essentiellement rigide disposé à la région centrale (19) de ladite couche de liaison pour obtenir une liaison forte et rigide entre la puce semi-conductrice (12) et le substrat (13), et une portion de couche essentiellement élastique (18) d'un agent de liaison essentiellement élastique disposé autour de ladite portion de couche rigide (17) dans le plan parallèle aux interfaces liées (15,16) de puce et de substrat, ladite portion de couche élastique (18) présentant une élasticité suffisante pour s'adapter aux différences de dilatation thermique entre ladite puce semi-conductrice et ledit substrat.

2. Dispositif semi-conducteur selon la revendication 1, dans lequel ledit agent de liaison rigide est une résine époxy et ledit agent de liaison élastique est une résine uréthane.

3. Dispositif semi-conducteur selon la revendication 1, dans lequel ledit agent de liaison rigide a un module de Young d'environ 9,02 GPa (920 kg/mm²) et ledit agent de liaison élastique a un module de Young d'environ 2,75 GPa (280 kg/mm²).

4. Dispositif semi-conducteur selon la revendication 1, dans lequel ladite couche de liaison (14) comprend en outre une portion de couche intermédiaire disposée entre ladite portion de couche rigide (17) et ladite portion de couche élastique (18), ladite portion de couche intermédiaire ayant une élasticité entre celles de ladite portion de couche rigide et de ladite portion de couche élastique.
